# EUROPEAN PATENT SPECIFICATION

(11) **EP 1 168 397 B1**
(45) Date of publication and mention of the grant of the patent: **18.08.2004**
(21) Application number: 00830448.7
(22) Date of filing: 26.06.2000
(51) Int. Cl.: H01H 33/59, H03K 17/0814

(54) **Static power switch device**
Statischer Leistungsschalter
Commutateur statique de puissance

(43) Date of publication of application: 02.01.2002
(73) Proprietor: ANSALDO RICERCHE S.r.l., 16161 Genova (IT)
(72) Inventor: Tenconi, Sandro Maria, 20144 Milano (IT)
(74) Representative: Eccetto, Mauro

(56) References cited:
- US-A- 5 103 154
- US-A- 5 598 311

## Description

The present invention relates to a static power switch device.

The present invention also relates to a method of controlling a static power switch device.

Power switches are known to be inserted between a supply source, e.g. a direct-voltage source, and one or more electric loads supplied by the source. For instance document US 5,598,311 discloses a power switch disposed between a DC supply source and a load supplied by the source. In such applications, the power switches are normally located close to the electric load and are connected to the supply source over electric cables which, in some cases, are of considerable length (even hundreds of meters), thus producing an inductive element in series with the electric loads and the power switch. Other possible inductive elements in series with the power switch are transformer or filter reactors.

Such inductive loads, which are often inevitable, are particularly critical by producing, when the power switch is opened, a rapid variation in current in the inductive load, and an overvoltage V according to the known law V = L(di/dt), where L is the total inductance of the circuit which is opened. The overvoltage is applied to the power switch and, in the absence of protective circuit elements in parallel with the switch (e.g. an arc eliminator or nonlinear resistors) could damage it. In particular, in the case of a static power switch employing semiconductor devices (e.g. MOS, IGBT or IGCT), the semiconductor device is subjected to voltages which may result in punch-through or breakdown of the silicon layers forming the semiconductor device.

The above phenomenon is even more critical when the power switch is opened in anomalous operating conditions, in particular in the presence of high current due to short-circuiting, e.g. of the load. In which case, the overvoltage applied to the power switch is even higher, by a current much higher than the normal load current being cut off extremely rapidly. Such a situation is typical in the case of a load with a protection circuit which, in the presence of high short-circuit currents, opens the power switch automatically.

It is an object of the present invention to provide a high-power static switch which may be used to advantage in medium-voltage circuits, and which, even in the presence of high, e.g. short-circuit, currents, may be opened repeatedly while at the same time remaining, with a suitable margin of safety, within the rated service range of semiconductor devices.

According to the present invention, there is provided a static power switch device as described in Claim 1.

The present invention also relates to a method of controlling a static power switch device as described in Claim 14.

A preferred, non-limiting embodiment of the invention will be described by way of example with reference to the accompanying drawings, in which:
Figure 1 shows a static power switch device in accordance with the teachings of the present invention;
Figure 2 shows a time graph of quantities (voltages and currents) of a switch device in accordance with the teachings of the present invention;
Figure 3 shows a first variation of the static power switch in Figure 1;
Figure 4 shows a second variation of the static switch in Figure 1;
Figure 5 shows an example application of the switch device according to the present invention;
Figure 6 shows a further example application of a switch device in accordance with the present invention;
Figure 7 shows a variation of the switch device employed in a three-phase circuit.

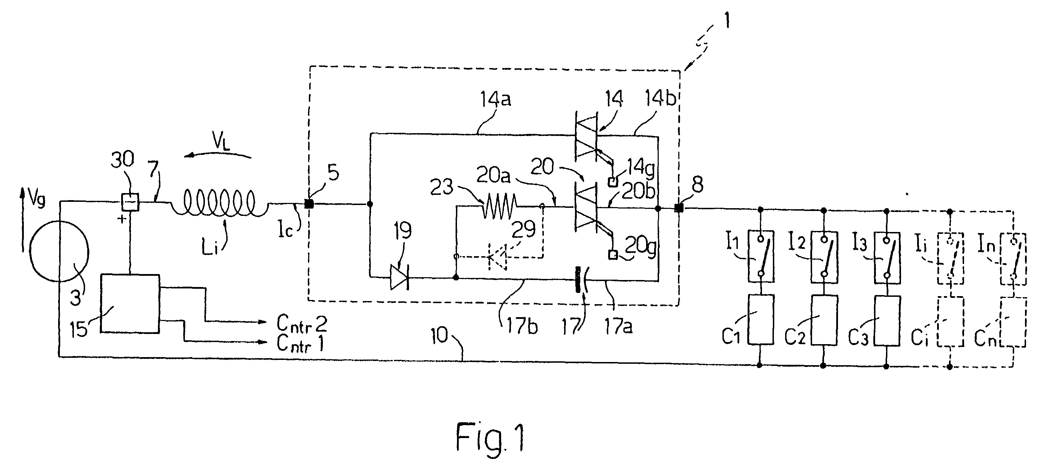

Number 1 in Figure 1 indicates as a whole a static power switch device insertable between a supply source 3 - in particular, a direct-voltage source Vg (e.g. a source for supplying a direct voltage of 3000 volts) - and one or more electric loads C supplied by source 3. The example embodiment shown has a number of electric loads C1, C2,C3, Ci,.., Cn in parallel with one another and each having a respective supply switch I1, I2, I3, Ii, .., In.

More specifically, switch device 1 has a first terminal 5 connected to a positive terminal of supply source 3 over an electric line 7; and a second terminal 8 connected to first terminals of supply switches I1, I2, I3, Ii, .., In. Supply switches I1, I2, I3, Ii, .., In have second terminals connected to first terminals of electric loads C1, C2, C3, Ci, .., Cn, which in turn have second terminals connected to a negative terminal of supply source 3 over an electric line 10.

Electric line 7 is defined by electric cables (not shown) of other than negligible length and inductance, and therefore defines, together with any other inductive elements (not shown), an inductive (or resistive inductive) load shown schematically by Figure 1 by an inductor L1.

Static power switch device 1 comprises a solid-state main switch 14 having a first and a second terminal 14a, 14b connected directly to first terminal 5 and second terminal 8 of static power switch 1 respectively.

Main switch 14 has an on-off control terminal 14g which receives a first control signal Cntr1 from a control device 15 (shown schematically) to close and open main switch 14.

Main switch 14 may be defined by any semiconductor switch device (e.g. MOS, IGBT, IEGT or IGCT) having an on-off control terminal.

Switch device 1 comprises a capacitor 17 having a first terminal 17a connected to second terminal 8, and a second terminal 17b connected to the cathode of a diode 19, the anode of which is connected to first terminal 5.

Device 1 also comprises a solid-state auxiliary switch 20 having a first and a second terminal 20a, 20b, and a control terminal 20g which is supplied by control device 15 with a control signal Cntr2 for closing and opening auxiliary switch 20. Like main switch 14, the auxiliary switch may be defined by any semiconductor switch device (e.g. MOS, IGBT, IEGT or IGCT) having an on-off control terminal.

More specifically, second terminal 20b of auxiliary switch 20 is connected to second terminal 8, and first terminal 20a is connected to a first terminal of a resistor 23, the second terminal of which is connected to second terminal 17b of capacitor 17.

Auxiliary switch 20 and resistor 23 are therefore in series with each other and form a branch in parallel with capacitor 17.

In parallel with resistor 23, provision may be made for a diode 29 (shown by the dash line) with the cathode connected to terminal 17b.

In actual use and in normal operating conditions (loaded with switches I1, I2, I3, Ii, .., In closed), switch 14 is closed thus connecting supply source 3 to electric loads C1, C2, C3, Ci, .., Cn.

Switch 20 may be closed or open in that, in steady operating conditions, its state has no substantial effect on operation of switch 1.

When switches 20 and 14 are both closed, the resistance of switch 14 is in the order of a milliohm, whereas that of resistor 23 is in the order of an ohm (e.g. 1.8 ohms), so that the load current Ic carried by electric line 7 flows mainly through main switch 14, and the current carried by auxiliary switch 20 is negligible. In steady operating conditions with both switches 14 and 20 closed, load current Ic is therefore mainly carried by main switch 14.

On the other hand, in the above steady operating conditions with main switch 14 closed and auxiliary switch 20 open, capacitor 17 acts as an open circuit, thus preventing current flow.

In steady operating conditions with switch 14 closed and switch 20 open, the load current is carried by main switch 14.

The potential drop at the terminals of main switch 14 is negligible (i.e. in the order of a few volts, and at any rate much smaller than the voltage supplied by source 3) and capacitor 17 is substantially discharged or is precharged as a function of operating requirements.

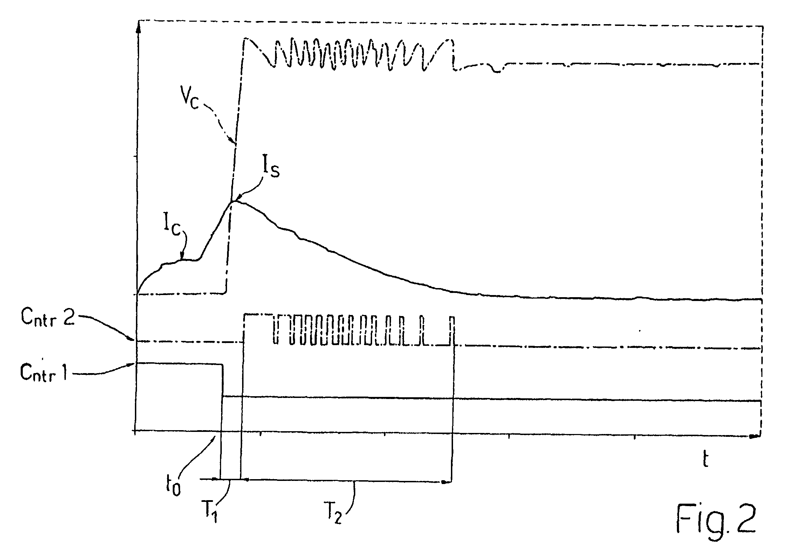

In the event one of loads C1, C2, C3, Ci, .., Cn short-circuits, load current Ic increases rapidly (Figure 2) towards the normally very high steady short-circuit current value Icc.

A current detector 30 (shown schematically) located along line 7 and cooperating with control device 15 opens device 1 automatically and in memorized manner when the current carried by line 7 and tending towards the short-circuit value (Icc) exceeds a threshold current Is.

To open device 1, main switch 14 is first opened (instant to Figure 2) ; control signal Cntr1 therefore changes state, e.g. from a first logic value (1) to a second logic value (0).

Following the transient state caused by the opening of switch 14, capacitor 17 (discharged or charged to a low voltage) is charged and initially behaves like a short-circuit.

The high short-circuit current therefore flows into capacitor 17, which is charged and stores energy; and the voltage Vc at the terminals of the capacitor increases as shown in Figure 2. The voltage Vc at the terminals of capacitor 17 also corresponds, minus the (negligible) potential drop at the terminals of diode 19, to the voltage between first terminal 5 and second terminal 8 of switch 1, and therefore to the voltage applied to the terminals of main switch 14, and would increase - according to the known law V = Li(di/dt), where Li is the total inductance of the inductive load defined by electric line 7 - beyond the blocking capacity of, and thus destroying, main static switch 14.

According to the present invention, auxiliary switch 20 (if not already closed) is turned on (closed) to connect resistor 23 in parallel with capacitor 17, so that current flows in resistor 23 and the energy stored in capacitor 17 is discharged to prevent any further increase in the voltage at the terminals of capacitor 17. Limiting the voltage at the terminals of capacitor 17 also limits the voltage between terminals 5 and 8 of switch 1, thus limiting the overvoltage applied to main switch 14.

Auxiliary switch 20 may be turned on in a number of ways, including:
. An open-loop control mode whereby, after a predetermined time T1 from when main switch 14 is opened (instant t₀), one or more closing and opening cycles of auxiliary switch 20 are performed for a predetermined time interval T2, so that control signal Cntr2 assumes a typical rectangular-wave pattern (Figure 2) varying between a first logic value (1) and a second logic value (0) to close and open auxiliary switch 20 respectively.
. A closed-loop control mode whereby the voltage at the terminals of capacitor 17 is monitored directly (e.g. by means of voltage transducers not shown), and, in the event the voltage exceeds threshold value Is, one or more closing and opening cycles of auxiliary switch 20 are performed until the measured voltage falls below a threshold value. In this case too, control signal Cntr2 assumes a typical rectangular-wave pattern (Figure 2) varying between a first logic value (1) and a second logic value (0) to close and open auxiliary switch 20 respectively. After a given number of opening and closing cycles, switch 20 is finally opened, and voltage Vc assumes substantially the same value as voltage Vg.

Diode 29 (optional) provides for protecting auxiliary switch 20 from the overvoltages induced by resistor 23. Resistor 23 in fact normally has a certain reactive component which, when auxiliary switch 20 is opened, could produce a dangerous overvoltage in switch 20, in which case, terminal 20a assumes a much higher potential level than the voltage at terminal 17b of capacitor 17. In such a condition, however, diode 29 begins conducting to discharge the energy of the inductive part of resistor 23, thus protecting auxiliary switch 20 from the overvoltages.

Finally, control device 15 may be supplied by an external supply source (not shown) or draw its own supply by absorbing energy from line 7 by means of a pickup device (not shown).

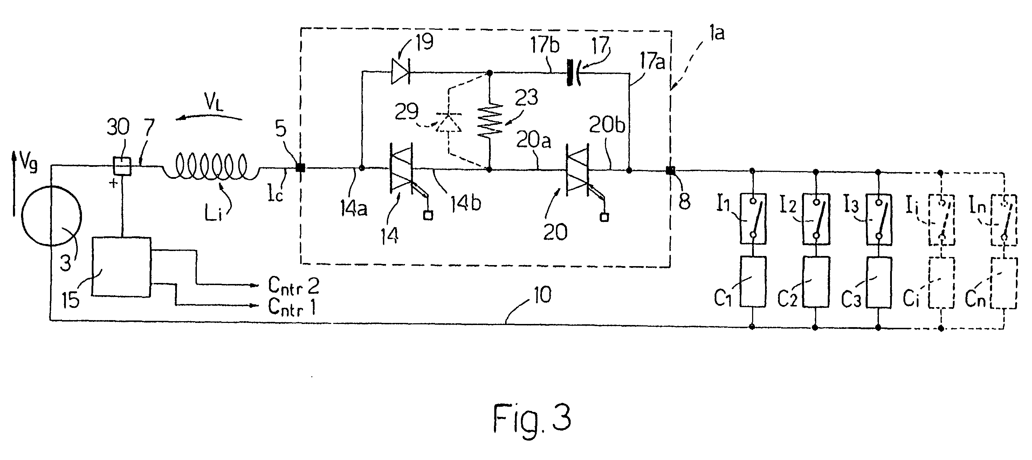

Figure 3 shows a first variation 1a of the Figure 1 static power switch, wherein solid-state main switch 14 and auxiliary switch 20 are in series with each other. More specifically, main switch 14 has its first terminal 14a connected to first terminal 5, and its second terminal 14b connected to first terminal 20a of auxiliary switch 20; auxiliary switch 20 has its second terminal 20b connected to second terminal 8; capacitor 17 has its first terminal 17a connected to second terminal 8, and its second terminal 17b connected to a first terminal of resistor 23, a second terminal of which is connected to terminals 14b and 20a; diode 19 has the anode connected to first terminal 5, and the cathode connected to the first terminal of resistor 23 and the second terminal 17b of capacitor 17; and, as in Figure 1, a diode 29 may be provided in parallel with resistor 23.

The Figure 3 static power switch operates in the same way as the Figure 1 switch, except that, in normal operating conditions (loaded with switches I1, I2, I3, Ii, .., In closed), switch 14 and auxiliary switch 20 are both closed to connect supply source 3 to electric loads C1, C2, C3, Ci, .., Cn.

The load current is thus carried by main switch 14 and auxiliary switch 20.

The potential drop at the terminals of main switch 14 and auxiliary switch 20 is negligible (i.e. in the order of a few volts, and at any rate much smaller than the voltage supplied by source 3) and capacitor 17 is substantially discharged.

In the event one of loads C1, C2, C3, Ci, .., Cn short-circuits, load current Ic increases rapidly (Figure 2) towards the normally very high steady short-circuit current value Icc.

Current detector 30 therefore opens device 1 where it is effected simultaneously the opening of main switch 14 (instant to Figure 2) and auxiliary switch 20 (not shown in Figure 2); and control signals Cntr1, Cntr2 therefore change state, e.g. from a first logic value (1) to a second logic value (0).

Following the transient state caused by the opening of switches 14 and 20, capacitor 17 (discharged) is charged via diode 19 and initially behaves like a short-circuit.

The high short-circuit current therefore flows through diode 19 into capacitor 17, which is charged and stores energy; and the voltage Vc at the terminals of the capacitor increases as shown in Figure 2. The voltage Vc at the terminals of capacitor 17 also corresponds, minus the (negligible) potential drop at the terminals of diode 19, to the voltage between first terminal 5 and second terminal 8 of switch 1, and therefore to the voltage applied to the terminals of main switch 14.

According to the present invention, auxiliary switch 20 is closed to connect resistor 23 in parallel with capacitor 17, so that current flows in resistor 23 and the energy stored in capacitor 17 is discharged to prevent any further increase in the voltage at the terminals of capacitor 17. Limiting the voltage at the terminals of capacitor 17 also limits the voltage between terminals 5 and 8 of switch 1, thus limiting the overvoltage applied to main switch 14.

As stated previously, auxiliary switch 20 may be put through one or more closing and opening cycles, which may be performed in a number of ways, including open-loop control mode and closed-loop control mode.

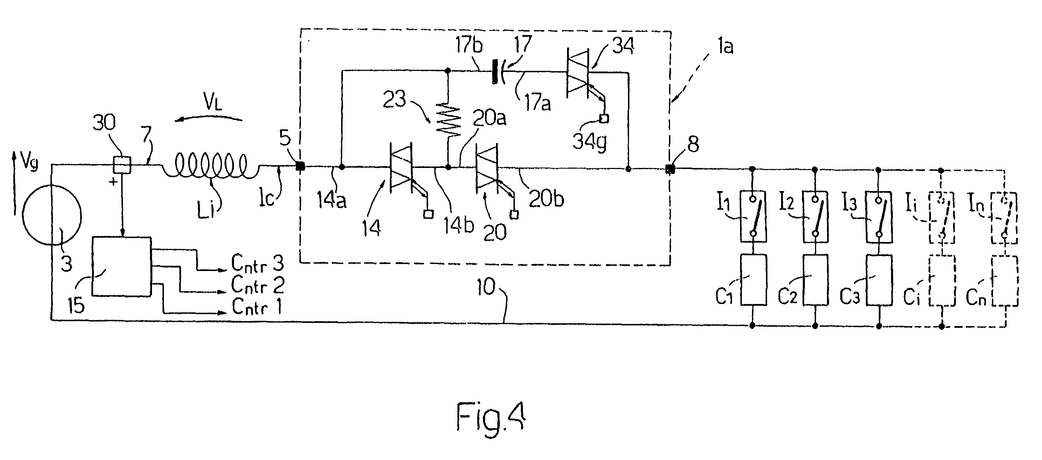

Figure 4 shows a second variation of the Figure 1 device, which substantially corresponds to the Figure 3 device, except that:
a semiconductor switch 34 is interposed between first terminal 17a of capacitor 17 and second terminal 8; and
diode 19 is replaced with a short-circuit - so that second terminal 17b of capacitor 17 is connected directly to terminal 5.

Switch 34 has a control terminal 34g supplied by control device 15 with a control signal Cntr3. More specifically, switch 34 is kept open when main switch 14 and auxiliary switch 20 are closed, to prevent discharging of capacitor 17, which may thus be charged to a predetermined voltage.

When switches 14 and 20 are opened, switch 34 is closed to direct the load current into capacitor 17, which is thus charged and stores energy. As before, when the voltage in capacitor 17 exceeds a threshold value (closed-loop control), or after a predetermined time interval from the opening of switches 14 and 20 (open-loop control), one or more closing/opening cycles of auxiliary switch 20 are performed to discharge capacitor 17 into resistor 23 and so limit the voltage increase in capacitor 17 and, hence, in switches 14 and 20.

The advantages of the switch device according to the present invention are as follows:
. Even when extinguishing high short-circuit current in the presence of inductive loads, the voltage applied to the terminals of main semiconductor switch 14 is prevented from increasing uncontrollably and causing irreparable damage to static switch 1. On the contrary, the voltage applied to main switch 14 is maintained at all times within safety values.
. Static power switch device 1 may advantageously be connected in series with other switches of the same structure, by the voltage at the terminals of the respective main switches being controlled in each switch device.
. The static power switch device described is extremely straightforward in design, is highly reliable, features commonly marketed components, and is cheap and easy to produce.

Clearly, changes may be made to the static switch devices described herein without, however, departing from the scope of the present invention as defined by the appended claims.

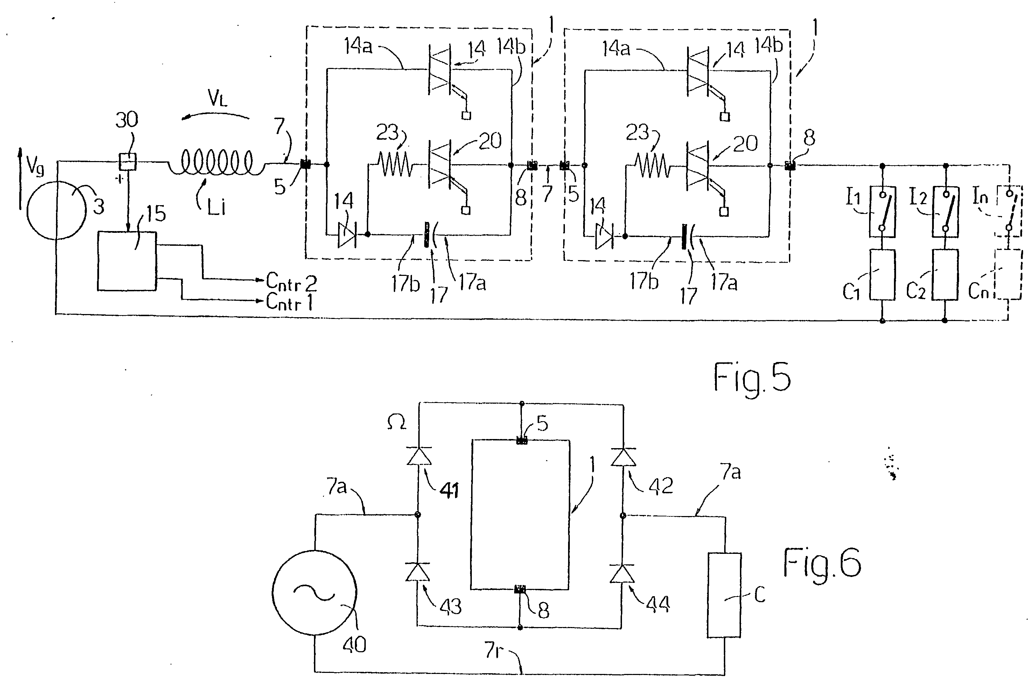

In particular:
. Clamping diodes (not shown) may be provided along line 7, in series with switch 1, to prevent current inversion.
. Recirculating diodes (not shown) may be provided in parallel with respective loads C1, C2, C3, Ci, .., Cn to prevent voltage inversion at the loads.
. Resistors may be provided in series with capacitor 17.
. Static switches 1, regardless of whether they are formed as shown in Figures 1, 3 or 4, may conveniently be connected in series with one another (Figure 5) along electric line 7; in which case, main switches 14 of the various switches 1 are opened synchronously.
. Switch 1 may also be inserted in a diode bridge structure supplied by a single-phase alternating supply source 40 (Figure 6). More specifically, a first terminal 5 of switch 1 may be connected to the cathodes of a first and second diode 41, 42 having respective anodes connected to the cathodes of a third and fourth diode 43, 44; the anodes of diodes 43, 44 are connected to each other and communicate with a second terminal 8 of switch 1; the anode of diode 41 and the cathode of diode 43 are connected by an electric line 7a to a first output of alternating source 40; and the anode of diode 42 and the cathode of diode 44 are connected by electric line 7a to a first input of load C, which has a second input connected to a second output of alternating source 40 by a return line 7r. When switch 1 is open, the positive/negative half-waves of the alternating voltage supplied by source 40 are prevented from crossing the diode bridge defined by diodes 41, 42, 43, 44, so that load C is not supplied. Conversely, when switch 1 is closed, the positive half-waves of the voltage reach load C via diodes 41 and 44, and the negative half-waves reach load C via diodes 43 and 42.

In other words, when switch device 1, located along the diagonal of the bridge, is closed, alternating currents may flow through the load. Conversely, when switch device 1 is open, no current flows into load C.

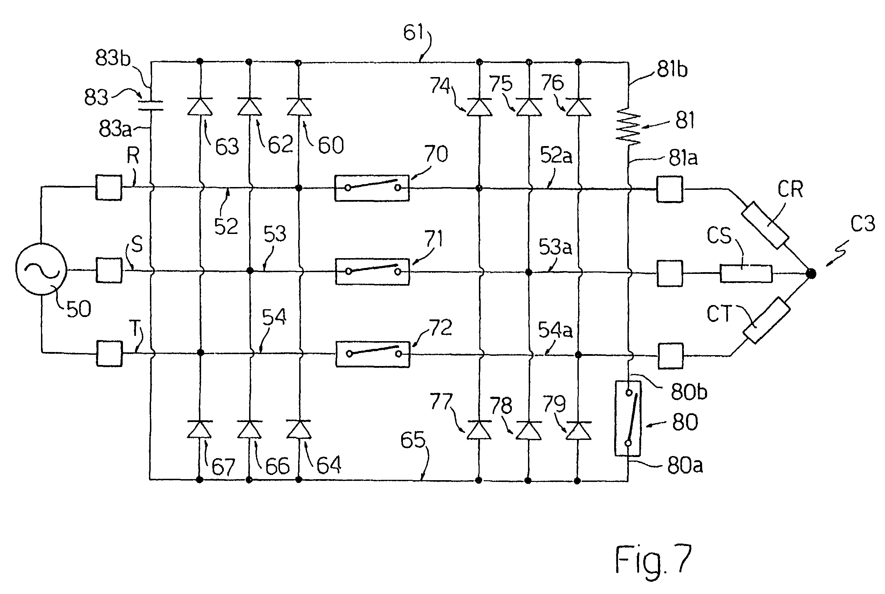

The switch device may also be used in a three-phase structure (Figure 7) employing three-phase voltage supplied by a three-phase source 50. More specifically, three-phase source 50 generates a first, a second and a third sinusoidal voltage (indicated R, S, T) and supplies them along respective electric lines 52, 53, 54.

The three-phase structure comprises:
. a first diode 60 having the anode connected to line 52, and the cathode connected to a line 61;
. a second diode 62 having the anode connected to line 53, and the cathode connected to line 61;
. a third diode 63 having the anode connected to line 54 and the cathode connected to line 61;
. a fourth diode 64 having the cathode connected to line 52 and the anode connected to a line 65;
. a fifth diode 66 having the cathode connected to line 53 and the anode connected to line 65; and
. a sixth diode 67 having the cathode connected to line 54, and the anode connected to line 65.

The three-phase structure also comprises first, second and third main semiconductor switches 70, 71, 72 located along electric lines 52, 53, 54 and permitting, when closed, two-directional current flow along lines 52, 53, 54. The portions of lines 52, 53, 54 downstream from the respective switches are indicated 52a, 53a, 54a.

The three-phase structure also comprises:
. a seventh diode 74 having the anode connected to line 52a, and the cathode connected to line 61;
. an eighth diode 75 having the anode connected to line 53a, and the cathode connected to line 61;
. a ninth diode 76 having the anode connected to line 54a and the cathode connected to line 61;
. a tenth diode 77 having the cathode connected to line 52a and the anode connected to line 65;
. an eleventh diode 78 having the cathode connected to line 53a and the anode connected to line 65; and
. a twelfth diode 79 having the cathode connected to line 54a, and the anode connected to line 65.

The switch according to the present invention comprises main switches 70, 71, 72; and one auxiliary switch 80 having a first terminal 80a connected to line 65, and a second terminal 80b connected to a first terminal 81a of a resistor 81, a second terminal 81b of which is connected to line 61. A single capacitor 83 has a first and a second terminal 83a, 83b connected to lines 65, 61 respectively, so that capacitor 83 is interposed between lines 61 and 65.

In actual use, when switches 70, 71, 72 are closed, the three-phase voltage from source 50 is applied to the terminals of a three-phase load C3 (defined, in the example shown, by three star-connected loads CR, CS, CT, though other arrangements are obviously possible), and a three-phase current flows along lines 52, 53, 54 to load C3. The supply current is thus carried by main switches 70, 71, 72, in which case, auxiliary switch 80 is preferably closed.

When switches 70, 71, 72 are opened (e.g. in the event of short-circuiting of load C3), the load currents are directed by diodes 60-67 to capacitor 83, which charges and absorbs energy.

Because of the inductances (not shown) along lines 52, 53, 54, overvoltages are produced along lines 52, 53, 54 and the voltage in capacitor 83 tends to rise. As stated previously, however, auxiliary switch 80 is activated to discharge capacitor 83 into resistor 81 and so limit the increase in voltage. The voltage at the terminals of capacitor 83 is thus controlled, and is also applied by pairs of diodes (diodes 60 and 77 for switch 70, for example) to the terminals of switches 70, 71, 72 to prevent a dangerous increase in voltage at the terminals of switches 70, 71, 72.

As can be seen, one auxiliary switch 80, one resistor 81 and one capacitor 83 provide for protecting three main switches.

## Claims

1. A static power switch device locatable along an electric line (7, 10), said electric line defining an inductive load (Li) between a supply source (3), in particular a direct-voltage source, and at least one electric load (C1, C2, C3, Ci, .., Cn) supplied by said source; said static power switch device comprising at least one main switch (14); said main switch (14) being located between a first and a second terminal (5, 8) of said static switch device to carry, when closed, a load current (Ic) for supplying said electric load;
the static power switch device also comprising capacitor means (17) which are supplied with at least part of said load current (Ic) when said main switch (14) is opened; at least part of the voltage in said capacitor means (17) being applied to the terminals of said main switch (14) ;
said static power switch device also comprising at least:
- an auxiliary switch (20); and
- resistor means (23) communicating with said auxiliary switch and with said capacitor means (17);
said auxiliary switch (20) being closable (Cntr2) to connect said resistor means (23) to said capacitor means (17) so that current flows into said resistor means (23) to effect at least a partial discharge of the energy supplied to the capacitor means (17) following the opening of said main switch; said discharge preventing an increase in the voltage in said capacitor means (17) **characterized in that** said main switch is a semiconductor switch; the static power switch device comprising control means (15) for operating one or more opening and dosing cycles of said auxiliary switch (20) to realize one or more cycles of charging and discharging of said capacitor means in order to keep the voltage on the capacitor between two limit values.

2. A device as claimed in Claim 1, **characterized in that** said auxiliary switch (20) and said resistor means (23) are in series with each other, and form a branch in parallel with said capacitor means (17).

3. A device as claimed in Claim 2, **characterized in that** said capacitor means (17) have a first terminal (17a) communicating (19) with a first terminal (14b) of the main switch; and a second terminal (17b) communicating with a second terminal (14a) of the main switch.

4. A device as claimed in Claim 3, **characterized in that** said second terminal (17b) of said capacitor means (17) communicates with said second terminal (14a) of the main switch via a diode (19).

5. A device as claimed in Claim 1 or 2, **characterized in that** said main switch (14) and said auxiliary switch are in series with each other.

6. A device as claimed in Claim 5, **characterized in that** a first terminal (17a) of said capacitor means (17) communicates with a first terminal (20b) of said auxiliary switch; and a second terminal (17b) of said capacitor means (17) communicates with a second terminal of said auxiliary switch via said resistor means (23).

7. A device as claimed in any one of the foregoing Claims, **characterized by** comprising at least one diode (19) interposed between a first output terminal of said static power switch (1) and a second terminal (17b) of said capacitor means (17); a first terminal (17a) of said capacitor means (17) communicating with a second terminal (8) of said static power switch (1).

8. A device as claimed in Claim 6, **characterized by** comprising cutout switches (34) in series with said capacitor means (17) and which, when open, prevent discharge of said capacitor means via the closed said auxiliary switch (20); said cutout switches (34) being closed when said main switch (14) is opened to permit current flow from said capacitor means (17) to said resistor means (23).

9. A device as claimed in any one of the foregoing Claims, **characterized by** comprising at least one diode (29) in parallel with said resistor means (23).

10. A device as claimed in claim 1, **characterized in that** said control means (15) provide for an open-loop control mode whereby, after a first predetermined time interval (T1) from the opening of the main switch (14), a number of closing and opening cycles of the auxiliary switch (20) are performed; said cycles being performed for a second predetermined time interval (T2).

11. A device as claimed in Claim 1, **characterized in that** said control means (15) provide for a closed-loop control mode whereby the voltage at the terminals of said capacitor means (17) is monitored directly and, upon said voltage exceeding a threshold value (Is), a number of closing and opening cycles of the auxiliary switch (20) are performed; said cycles being performed until the voltage in said capacitor means (17) falls below a threshold value.

12. A method of controlling a static power switch device located along an electric line (7, 10), said electric line defining an inductive load (Li) between a supply source (3), in particular a direct-voltage source, and at least one electric load (C1, C2, C3, Ci, .., Cn) supplied by said source; said static power switch device comprising a main semiconductor switch (14); and said method comprising the steps of:
- opening the main switch (14) to supply capacitor means (17) with at least part of the load current (Ic) carried by the main switch;
- closing an auxiliary switch (20) to connect resistor means (23) to the capacitor means (17) so that current flows into said resistor means (23) to effect at least a partial discharge of the energy supplied to the capacitor means (17) following the opening of said main switch; said discharge preventing an increase in the voltage in said capacitor means (17); and
- applying at least part of the voltage in said capacitor means (17) to said main switch; and whereby a control means (15) of the static power switch device is operating one or more opening and closing cycles of said auxiliary switch (20) to realize one or more cycles of charging and discharging of said capacitor means in order to keep the voltage on the capacitor between two limit values.

13. A method as claimed in Claim 12, **characterized by** comprising the step of open-loop controlling (15) the switching of said auxiliary switch (20); said open-loop control step comprising the step of performing a number of closing and opening cycles of the auxiliary switch (20) following a predetermined first time interval (T1) from the opening of the main switch (14); said closing and opening cycles being performed for a predetermined second time interval (T2).

14. A method as claimed in Claim 12, **characterized by** comprising the step of closed-loop controlling (15) the switching of said auxiliary switch (20); said closed-loop control step comprising the step of monitoring the voltage at the terminals of said capacitor means (17), and, in the event said voltage exceeds a threshold value, performing a number of closing and opening cycles of the auxiliary switch (20); said closing and opening cycles being performed until the voltage in said capacitor means (17) falls below a threshold value.

## Patentansprüche

1. Statischer Leistungsschalter, der in einer elektrischen Leitung (7,10) anordbar ist, wobei die elektrische Leitung eine induktive Last (Li) zwischen einer Versorgungsquelle (3), insbesondere einer Direktspannungsquelle, und mindestens einer elektrischen Last (C1, C2, C3, Ci, ..., Cn), die durch die Quelle versorgt wird, definiert ist,
wobei der statische Leistungsschalter mindestens einen Hauptschalter (14) umfasst, wobei der Hauptschalter (14) zwischen einem ersten und einem zweiten Anschluss (5,8) des statischen Schalters angeordnet ist, um in geschlossenem Zustand einen Laststrom (Ic) zur Versorgung der elektrischen Last aufzunehmen, wobei der statische Leistungsschalter weiterhin eine Kapazitätseinrichtung (17) aufweist, die durch mindestens einen Teil des Laststroms (Ic) versorgt wird, wenn der Hauptschalter (14) geöffnet wird, wobei mindestens ein Teil der Spannung in der Kapazitätseinrichtung (17) an die Anschlüsse des Hauptschalters (14) angelegt ist,
wobei der statische Leistungsschalter auch weiterhin mindestens umfasst:
- einen Hilfsschalter (20); und
- eine Widerstandseinrichtung (23), die mit dem Hilfsschalter und mit der Kapazitätseinrichtung (17) verbunden ist;
- wobei der Hilfsschalter (20) geschlossen werden kann (Cntr2), um die Widerstandseinrichtung (23) mit der Kapazitätseinrichtung (17) zu verbinden, so dass ein Strom in die Widerstandseinrichtung (23) fließt, um mindestens eine teilweise Entladung von Energie, die von der Kapazitätseinrichtung (17) bereitgestellt wird, nach dem Öffnen des Hauptschalters zu bewirken, wobei das Entladen ein Ansteigen der Spannung in der Kapazitätseinrichtung (17) verhindert,
**dadurch gekennzeichnet,**
**dass** der Hauptschalter ein Halbleiterschalter ist ;
wobei der statische Leistungsschalter eine Steuereinrichtung (15) aufweist, um ein oder mehrere Öffnungs- und Schließzyklen des Hilfsschalters (20) zu bewirken, so dass einer oder mehrere Lade- und Entladezyklen der Kapazitätseinrichtung realisiert werden, um die Spannung über der Kapazitätseinrichtung zwischen zwei Grenzwerten zu halten.

2. Schalter nach Anspruch 1, **dadurch gekennzeichnet, dass** der Hilfsschalter (20) und die Widerstandseinrichtung (23) zueinander in Serie geschaltet sind und einen parallelen Zweig zu der Kapazitätseinrichtung (17) bilden.

3. Schalter nach Anspruch 2, **dadurch gekennzeichnet, dass** die Kapazitätseinrichtung (17) einen ersten Anschluss (17a) aufweist, der mit einem ersten Anschluss (14b) des Hauptschalters verbunden (19) ist; und einen zweiten Anschluss (17b), der mit einem zweiten Anschluss (14a) des Hauptschalters verbunden ist.

4. Schalter nach Anspruch 3, **dadurch gekennzeichnet, dass** der zweite Anschluss (17b) der Kapazitätseinrichtung (17) mit dem zweiten Anschluss (14a) des Hauptschalters über eine Diode (19) verbunden ist.

5. Schalter nach Anspruch 1 oder 2, **dadurch gekennzeichnet, dass** der Hauptschalter (14) und der Hilfsschalter zueinander in Serie geschaltet sind.

6. Schalter nach Anspruch 5, **dadurch gekennzeichnet, dass** ein erster Anschluss (17a) der Kapazitätseinrichtung (17) mit einem ersten Anschluss (20b) des Hilfsschalters verbunden ist; und dass ein zweiter Anschluss (17b) der Kapazitätseinrichtung (17) mit einem zweiten Anschluss des Hilfsschalters über die Widerstandseinrichtung (23) verbunden ist.

7. Schalter nach einem der vorangehenden Ansprüche, **dadurch gekennzeichnet, dass** er zumindest eine Diode (19) aufweist, die zwischen einem ersten Ausgangsanschluss des statischen Leistungsschalters (1) und einem zweiten Anschluss (17b) der Kapazitätseinrichtung (17) angeordnet ist, wobei ein erster Anschluss (17a) der Kapazitätseinrichtung (17) mit einem zweiten Anschluss (8) des statischen Leistungsschalters (1) verbunden ist.

8. Schalter nach Anspruch 6, **dadurch gekennzeichnet, dass** der Schalter mit der Kapazitätseinrichtung (17) in Reihe geschaltete Sicherungsausschalter (34) aufweist, die in geöffnetem Zustand das Entladen der Kapazitätseinrichtung über den geschlossenen Hilfsschalter (20) verhindert, wobei die Sicherungsausschalter (34) geschlossen sind, wenn der Hauptschalter (14) geöffnet ist, um einen Stromfluss von der Kapazitätseinrichtung (17) an die Widerstandseinrichtung (23) zu ermöglichen.

9. Schalter nach einem der vorangehenden Ansprüche, **dadurch gekennzeichnet, dass** der Schalter mindestens eine Diode (29) aufweist, die mit der Widerstandseinrichtung (23) parallel geschaltet ist.

10. Schalter nach Anspruch 1, **dadurch gekennzeichnet, dass** die Steuereinrichtung (15) einen Steuerungsmodus zur Verfügung stellt, in dem nach einer ersten vorbestimmten Zeitdauer (T1) nach dem Öffnen des Hauptschalters (14) eine Anzahl von Schließ- und Öffnungszyklen des Hilfsschalters (20) durchgeführt werden, wobei die Zyklen während einer zweiten vorbestimmten Zeitdauer (T2) durchgeführt werden.

11. Schalter nach Anspruch 1, **dadurch gekennzeichnet, dass** die Steuereinrichtung (15) einen Regelungsmodus zur Verfügung stellt, in dem die Spannung an den Anschlüssen der Kapazitätseinrichtung (17) direkt überwacht wird und wenn die Spannung einen Schwellwert (Is) übersteigt, wird eine Anzahl von Schließ- und Öffnungszyklen des Hilfsschalters (20) durchgeführt, wobei die Zyklen durchgeführt werden, bis die Spannung über der Kapazitätseinrichtung (17) unter einen Schwellwert fällt.

12. Verfahren zum Steuern eines statischen Leistungsschalters, der in einer elektrischen Leitung (7,10) angeordnet ist, wobei die elektrische Leitung eine induktive Last (Li) zwischen einer Versorgungsquelle (3), insbesondere einer Direktspannungsquelle, und mindestens einer elektrischen Last (C1, C2, C3, Ci, .... Cn), die durch die Quelle versorgt wird, definiert ist, wobei der statische Leistungsschalter einen Haupthalbleiterschalter (14) umfasst, mit folgenden Schritten:
- Öffnen des Hauptschalters (14) um eine Kapazitätseinrichtung (17) mit mindestens einem Teil des Laststroms (Ic), der durch den Hauptschalter getragen wird, zu versorgen;
- Schließen eines Hilfsschalters (20), um eine Widerstandseinrichtung (22) mit der Kapazitätseinrichtung (17) so zu verbinden, dass Strom in die Widerstandseinrichtung (23) fließt, um mindestens eine teilweise Entladung der Energie, die der Kapazitätseinrichtung (17) zugeführt wird, nach dem Öffnen des Hauptschalters zu bewirken, wobei das Entladen ein Ansteigen der Spannung über der Kapazitätseinrichtung (17) verhindert; und
- Anlegen zumindest eines Teils der Spannunq über der Kapazitätseinrichtung (17) an den Hauptschalter; und wobei eine Steuereinrichtung (15) des statischen Leistungsschalters ein oder mehrere Öffnungs- und Schließzkylen des Hilfsschalters (20) steuert, so dass einer oder mehrere Lade- und Entladungszyklen der Kapazitätseinrichtung realisiert werden, um die Spannung über der Kapazitätseinrichtung zwischen zwei Grenzwerten zu halten.

13. Verfahren nach Anspruch 12, **gekennzeichnet durch** den weiteren Schritt des Steuerns des Schaltens des Hilfsschalters (20); wobei der Schritt des Steuerns den Schritt des Durchführens einer Anzahl von Schließ- und Öffnungszyklen des Hilfsschalters (20) nach einer vorbestimmten ersten Zeitdauer (T1) nach dem Öffnen des Hauptschalters (14) umfasst,; wobei die Schließ- und Öffnungszyklen während einer vorbestimmten zweiten Zeitdauer (T2) durchgeführt werden.

14. Verfahren nach Anspruch 12, **gekennzeichnet durch** den Schritt des Regelns des Schaltens des Hilfsschalters (20); wobei der Schritt des Regelns den Schritt des Überwachens der Spannung an den Anschlüssen der Kapazitätseinrichtung (17) umfasst, und wobei im Fall, dass die Spannung einen Schwellwert übersteigt, eine Anzahl von Schließ- und Öffnungszyklen des Hilfsschalters (20) durchgeführt wird; wobei die Schließ- und Öffnungszyklen durchgeführt werden, bis die Spannung über der Kapazitätseinrichtung (17) unter einen Schwellwert fällt.

## Revendications

1. Commutateur statique de puissance pouvant être placé le long d'une ligne électrique (7, 10), ladite ligne électrique définissant une charge inductive (Li) entre une source d'alimentation (3), en particulier une source de tension continue, et au moins une charge électrique (C1, C2, C3, ..., Cn) alimentée par ladite source ; ledit commutateur statique de puissance comprenant au moins un commutateur principal (14) ; ledit commutateur principal (14) étant situé entre une première et une seconde bornes (5, 8) dudit commutateur statique pour acheminer, lorsqu'il est fermé, un courant de charge (Ic) pour alimenter ladite charge électrique ;
le commutateur statique de puissance comprenant également des éléments capacitifs (17) qui sont alimentés avec au moins une partie dudit courant de charge (Ic) lorsque ledit commutateur (14) est ouvert ; au moins une partie de la tension dans ledit élément capacitif (17) étant appliquée aux bornes dudit commutateur principal (14) ;
ledit commutateur statique de puissance comprenant également au moins :
un commutateur auxiliaire (20) ; et
un élément résistif (23) communiquant avec ledit commutateur auxiliaire et avec ledit élément capacitif (17) ;
ledit commutateur auxiliaire (20) étant pouvant être fermé (Cntr2) pour connecter ledit élément résistif (23) au dit élément capacitif (17) de manière à ce que le courant s'écoule dans ledit moyen résistif (23) pour réaliser au moins une décharge partielle de l'énergie fournie à l'élément capacitif (17) suite à l'ouverture dudit commutateur principal ; ladite décharge empêchant un accroissement de la tension dans ledit élément capacitif (17), **caractérisé en ce que** ledit commutateur principal est un commutateur à semi-conducteur ; le commutateur statique de puissance comprenant un moyen de commande (15) pour commander un ou plusieurs cycles d'ouverture et de fermeture dudit commutateur auxiliaire (20) pour réaliser un ou plusieurs cycles de charge et de décharge dudit élément capacitif de manière à maintenir la tension appliquée au condensateur entre deux valeurs limites.

2. Commutateur tel que revendiqué dans la revendication 1, **caractérisé en ce que** ledit commutateur auxiliaire (20) et ledit élément résistif (23) sont montés en série l'un avec l'autre et forment une branche en parallèle avec ledit élément capacitif (17).

3. Commutateur tel que revendiqué dans la revendication 2, **caractérisé en ce que** ledit élément capacitif (17) possède une première borne (17a) communiquant (19) avec une première borne (14b) du commutateur principal ; et une seconde borne (17b) communiquant avec une seconde borne (14a) du commutateur principal.

4. Commutateur tel que revendiqué dans la revendication 3, **caractérisé en ce que** ladite seconde borne (17b) dudit élément capacitif (17) communique avec ladite seconde borne (14a) du commutateur principal via une diode (19).

5. Commutateur tel que revendiqué dans les revendications 1 ou 2, **caractérisé en ce que** ledit commutateur principal (14) et ledit commutateur auxiliaire sont montés en série l'un avec l'autre.

6. Commutateur tel que revendiqué dans la revendication 5, **caractérisé en ce qu'**une première borne (17a) dudit élément capacitif (17) communique avec une première borne (20b) dudit commutateur auxiliaire ; et une seconde borne (17b) dudit élément capacitif (17) communique avec une seconde borne dudit commutateur auxiliaire via ledit élément résistif (23).

7. Commutateur tel que revendiqué dans l'une quelconque des revendications précédentes, **caractérisé en ce qu'**il comprend au moins une diode (19) interposée entre une première borne de sortie dudit commutateur statique de puissance (1) et une seconde borne (17b) dudit élément capacitif (17) ; une première borne (17a) dudit élément capacitif (17) communiquant avec une seconde borne (8) dudit commutateur statique de puissance (1).

8. Commutateur tel que revendiqué dans la revendication 6, **caractérisé en ce qu'**il comprend des coupe-circuits (34) montés en série avec ledit élément capacitif (17) et le commutateur, et qui, lorsqu'il est ouvert, empêche la décharge dudit élément capacitif via ledit commutateur auxiliaire (20) fermé ; lesdits coupe-circuits (34) étant fermés lorsque ledit commutateur principal (14) est ouvert pour permettre au courant de s'écouler depuis ledit élément capacitif (17) vers ledit élément résistif (23).

9. Commutateur tel que revendiqué dans l'une quelconque des revendications précédentes, **caractérisé en ce qu'**il comprend au moins une diode (29) montée en parallèle avec ledit élément résistif (23).

10. Commutateur tel que revendiqué dans la revendication 1, **caractérisé en ce que** ledit élément de commande (15) propose un mode de commande en boucle ouverte moyennant quoi, après un premier intervalle de temps prédéterminé (T1) à partir de l'ouverture du commutateur principal (14), un certain nombre de cycles de fermeture et d'ouverture du commutateur auxiliaire (20) sont effectués ; lesdits cycles étant effectués pendant un second intervalle de temps prédéterminé (T2).

11. Commutateur tel que revendiqué dans la revendication 1, **caractérisé en ce que** ledit moyen de commande (15) propose un mode de commande en boucle fermée moyennant quoi la tension aux bornes dudit élément capacitif (17) est directement contrôlée et, lorsque ladite tension dépasse une valeur seuil (Is), un certain nombre de cycles de fermeture et d'ouverture du commutateur auxiliaire (20) sont effectués ; lesdits cycles étant effectués jusqu'à ce que la tension dans ledit élément capacitif (17) chute au-dessous d'une valeur seuil.

12. Procédé de commande d'un commutateur statique de puissance situé le long d'une ligne électrique (7, 10), ladite ligne électrique définissant une charge inductive (Li) entre une source d'alimentation (3), en particulier une source de tension continue, et au moins une charge électrique (C1, C2, C3, ..., Cn) alimentée par ladite source ; ledit commutateur statique de puissance comprenant un commutateur principal à semi-conducteur (14) ; et ledit procédé comprenant les étapes consistant à :
ouvrir le commutateur principal (14) pour alimenter le moyen capacitif (17) avec au moins une partie du courant de charge (Ic) acheminé par le commutateur principal ;
fermer un commutateur auxiliaire (20) pour connecter l'élément résistif (23) à l'élément capacitif (17) de manière à ce que le courant s'écoule dans ledit moyen résistif (23) pour réaliser au moins une décharge partielle de l'énergie fournie à l'élément capacitif (17) suite à l'ouverture dudit commutateur principal ; ladite décharge empêchant un accroissement de la tension dans ledit élément capacitif (17) ; et
appliquer au moins une partie de la tension dans ledit élément capacitif (17) au dit commutateur principal ; et moyennant quoi un moyen de commande (15) du commutateur statique de puissance commande un ou plusieurs cycles d'ouverture et de fermeture dudit commutateur auxiliaire (20) pour réaliser un ou plusieurs cycles de charge et de décharge dudit élément capacitif de manière à maintenir la tension appliquée au condensateur entre deux valeurs limites.

13. Procédé tel que revendiqué dans la revendication 12, **caractérisé en ce qu'**il comprend l'étape consistant à commander en boucle ouverte (15) la commutation dudit commutateur auxiliaire (20) ; ladite étape de commande en boucle ouverte comprenant l'étape consistant à effectuer un certain nombre de cycles de fermeture et d'ouverture du commutateur auxiliaire (20) après un premier intervalle de temps prédéterminé (T1) à partir de l'ouverture du commutateur principal (14) ; lesdits cycles d'ouverture et de fermeture étant effectués pendant un second intervalle de temps prédéterminé (T2).

14. Procédé tel que revendiqué dans la revendication 12, **caractérisé en ce qu'**il comprend l'étape consistant à commander en boucle fermée (15) la commutation dudit commutateur auxiliaire (20) ; ladite étape de commande en boucle fermée comprenant l'étape consistant à contrôler la tension aux bornes dudit moyen capacitif (17) et, dans le cas où ladite tension dépasse une valeur seuil, effectuer un certain nombre de cycles de fermeture et d'ouverture du commutateur auxiliaire (20) ; lesdits cycles de fermeture et d'ouverture étant effectués jusqu'à ce que la tension dans ledit élément capacitif (17) chute au-dessous d'une valeur seuil.
